# EUROPEAN PATENT APPLICATION

(11) **EP 4 790 486 A1**
(43) Date of publication of application: **12.08.2026**
(21) Application number: 26156717.6
(22) Date of filing: 05.02.2026
(51) Int. Cl.: G03F 1/22, G03F 1/24, G03F 1/50, G03F 1/52, G03F 1/54

(54) **REFLECTIVE MASK BLANK AND REFLECTIVE MASK**

(30) Priority: 06.02.2025 JP 2025018153
(71) Applicant: SHIN-ETSU CHEMICAL CO., LTD., Tokyo 100-0005 (JP)
(72) Inventor: OGOSE, Taiga, Niigata, 942-8601 (JP); KAWAMURA, Ryoto, Niigata, 942-8601 (JP); INAZUKI, Yukio, Niigata, 942-8601 (JP); ARATA, Yuta, Niigata, 942-8601 (JP)
(74) Representative: Hindles Limited

(57) **Abstract**

A reflective mask blank 100 has a substrate 1; a multilayer reflective film 2 that reflects exposure light and that is provided on one main surface of the substrate 1; and an absorber film 5 provided above the multilayer reflective film 2. The absorber film 5 contains one or both of ruthenium (Ru) and platinum (Pt), and further contains one or both of carbon (C) and silicon (Si). A surface of the absorber film 5 has a root mean square roughness (Sq) of 0.40 nm or less.

## Description

### TECHNICAL FIELD

The present invention relates to a reflective mask blank that is a material for a reflective mask used for manufacturing a semiconductor device such as an LSI, and a reflective mask which is manufactured from the reflective mask blank.

### BACKGROUND ART

In the manufacturing process of semiconductor devices, a photolithography technique for irradiating a transfer mask with exposure light and transferring a circuit pattern formed on the mask onto a semiconductor substrate (semiconductor wafer) via a reduction projection optical system is repeatedly used. In the related art, the wavelength of exposure light is mainly 193 nm, which is argon fluoride (ArF) excimer laser light, and a pattern having smaller dimensions than the exposure wavelength has been finally formed by adopting a process called multi-patterning in which an exposure process and a processing process are combined a plurality of times.

However, it has been necessary to form even finer patterns due to continuous miniaturization of device patterns, and thus an EUV lithography technique using extreme ultraviolet (hereinafter, referred to as "EUV") light having a wavelength shorter than that of ArF excimer laser light as exposure light has been used. EUV light is light having a wavelength of about 0.2 to 100 nm, more specifically, light having a wavelength of around 13.5 nm. Since EUV light has extremely low transparency to substances, transmission type projection optical systems and masks of the related art cannot be used, and thus reflection type optical elements are used. Therefore, a reflective mask is also used as a mask for pattern transfer.

In the reflective mask, a multilayer reflective film that reflects EUV light is formed on a substrate, and a pattern of an absorption film that absorbs EUV light is formed on the multilayer reflective film. Meanwhile, the material before patterning of the absorption film (including the material with a resist film formed thereon) is called a reflective mask blank, and the reflective mask blank is used as a material for the reflective mask. In general, the reflective mask blank has a basic structure including a low thermal expansion substrate, a multilayer reflective film that reflects EUV light and is formed on one of two main surfaces of the substrate, and an absorption film that absorbs EUV light and is formed on the multilayer reflective film.

As the multilayer reflective film, a multilayer reflective film that obtains a necessary reflectivity for EUV light by alternately laminating a molybdenum (Mo) layer and a silicon (Si) layer is usually used. As the absorption film, tantalum (Ta) or the like having a relatively large extinction coefficient for EUV light is used (JP 2002-246299 A).

Furthermore, as a protective film (capping film) for protecting the multilayer reflective film during washing of the reflective mask or the like, a ruthenium (Ru) film or a rhodium (Rh) film as disclosed in JP 2002-122981 A or JP 2005-516182 A is formed on the multilayer reflective film. In addition, as an etching mask for when a pattern is formed on the absorption film, a hard mask film containing chromium (Cr) may be formed on the absorption film. Meanwhile, a conductive film is formed on the other main surface of the substrate. As the conductive film, a metal nitride film is proposed for electrostatic chucking, and examples thereof include films mainly containing chromium (Cr) and tantalum (Ta).

### SUMMARY OF INVENTION

### PROBLEM TO BE SOLVED BY INVENTION

In EUV lithography, the EUV light, which is the exposure light, is incident on the reflective mask from an oblique angle, and it has become mainstream to set the incident angle to 6 degrees with respect to the normal of the main surface of the reflective mask. A part of the exposure light incident from an oblique angle is blocked by the sidewall of the absorber pattern, and a so-called 3D effect (three-dimensional effect, shadowing effect) occurs. The 3D effect causes positional shifts and dimensional deviations in the transferred pattern, and a smaller 3D effect is preferable for pattern miniaturization. The thinner the thickness, the smaller the 3D effect becomes, and thus thinning of the absorber pattern is desirable.

Ruthenium (Ru) is a material that has a lower refractive index and a smaller extinction coefficient for EUV light, which is the exposure light, than tantalum (Ta). A reflective mask using ruthenium (Ru) in the circuit pattern can provide a phase shift effect that reflects a part of the exposure light with a phase shift of approximately 150° to 250°, thereby enabling higher contrast with a thinner film thickness and reducing the 3D effect. In addition, platinum (Pt) is a material that has a refractive index close to that of ruthenium (Ru) and an extinction coefficient larger than that of tantalum (Ta), and similarly, by providing a phase shift effect, the 3D effect can be reduced.

An absorber film made of ruthenium (Ru) or platinum (Pt) is likely to form crystals during film formation, and the grown crystal grains are likely to increase surface roughness. A reflective mask blank having an absorber film with increased surface roughness is more likely to generate pseudo-defects caused by the surface roughness when defect inspection using light such as visible light, ultraviolet light, or EUV light is performed. In order to separate pseudo-defects caused by surface roughness from actual defects that affect pattern transfer, a process of distinguishing between them is required, resulting in an increase in inspection time. Alternatively, when the inspection sensitivity is lowered to prevent pseudo-defects caused by surface roughness from occurring, there is a risk that actual defects affecting pattern transfer may not be detected.

Therefore, it is desirable that the absorber film has low surface roughness.

### MEANS FOR SOLVING PROBLEM

The inventors of the present invention, as a result of extensive studies to solve the above problems, have found that, in an absorber film containing one or both of ruthenium (Ru) and platinum (Pt), the surface roughness of the absorber film is reduced by further including one or both of carbon (C) and silicon (Si), thereby achieving the present invention.

In the present invention, the following aspects are provided.

A reflective mask blank according to the present invention may comprise:
a substrate;
a multilayer reflective film that reflects exposure light and that is provided on one main surface of the substrate; and
an absorber film provided above the multilayer reflective film,
wherein the absorber film contains one or both of ruthenium (Ru) and platinum (Pt), and further contains one or both of carbon (C) and silicon (Si), and
wherein a surface of the absorber film has a root mean square roughness (Sq) of 0.40 nm or less.

In the reflective mask blank according to the present invention,
a full width at half maximum corresponding to a diffraction angle 2θ of diffraction peak with highest intensity observed between diffraction angles 2θ of 30° and 50° in an X-ray diffraction pattern for the absorber film by an out-of-plane measurement method using CuK_{α} rays may be 0.60° or more.

In the reflective mask blank according to the present invention,
an absolute value of film stress of the absorber film may be 2,000 MPa or less.

In the reflective mask blank according to the present invention,
the absorber film may include carbon (C), and
a content rate of the carbon (C) in the absorber film may be 4 atomic% or more and 40 atomic% or less.

In the reflective mask blank according to the present invention,
the absorber film may include silicon (Si), and
a content rate of the silicon (Si) may be the absorber film is 4 atomic% or more and 40 atomic% or less.

The reflective mask blank according to the present invention may further comprise
a protective film containing one or both of ruthenium (Ru) and rhodium (Rh) and provided between the multilayer reflective film and the absorber film.

The reflective mask blank according to the present invention may further comprise
an etching stopper film provided between the protective film and the absorber film, the etching stopper film containing at least one selected from niobium (Nb), tantalum (Ta), silicon (Si), and chromium (Cr).

The reflective mask blank according to the present invention may further comprise
a hard mask film provided above the absorber film, the hard mask film containing at least one selected from niobium (Nb), tantalum (Ta), silicon (Si), and chromium (Cr).

In a reflective mask according to the present invention,
the absorber film of the above reflective mask blank has an absorber pattern.

### EFFECT OF INVENTION

According to the present invention, the absorber film can have low surface roughness.

### BRIEF DESCRIPTION OF DRAWINGS

FIG. 1 shows a cross-sectional view showing an example of a reflective mask blank according to an embodiment of the present invention;
FIG. 2 is a cross-sectional view showing an example in which a hard mask film is provided in the reflective mask blank according to the embodiment of the present invention;
FIG. 3 shows a cross-sectional view showing an example of a reflective mask according to an embodiment of the present invention; and
FIG. 4 is a cross-sectional view showing an example in which a hard mask film and a resist film are provided in the reflective mask blank according to the embodiment of the present invention.

### DETAILED DESCRIPTION

Hereinafter, embodiments of the present invention will be described in greater detail.

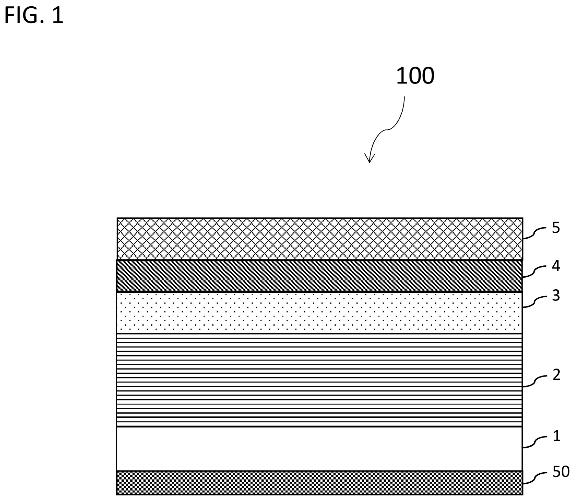

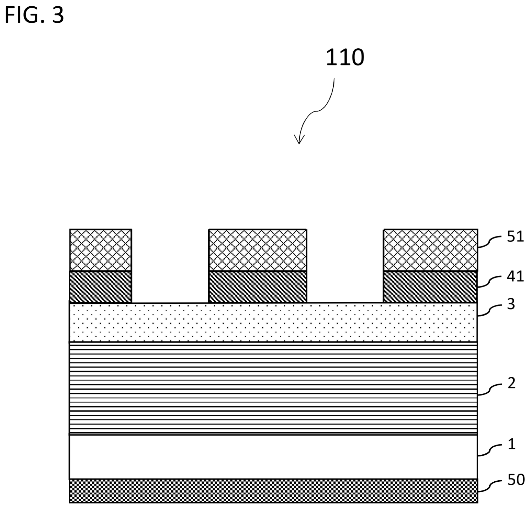

As shown in FIG. 1, a reflective mask blank 100 of the present embodiment includes a substrate 1, a multilayer reflective film 2 that reflects exposure light formed on the substrate 1 (on one main surface (front surface) of the substrate 1), and an absorber film 5 formed above the multilayer reflective film 2. The reflective mask blank 100 of the present embodiment is suitable as a material (EUV mask blank) of a reflective mask 110 (EUV mask) as shown in FIG. 3 used in EUV lithography using EUV light as exposure light. The wavelength of EUV light used for EUV lithography using EUV light as exposure light is 13 to 14 nm, and is usually light having a wavelength of about 13.5 nm.

The substrate 1 preferably has low thermal expansion characteristics for EUV light exposure, and for example, the substrate 1 is preferably formed of a material having a thermal expansion coefficient within a range of ±2 × 10⁻⁸ /°C, preferably ±5 × 10⁻⁹ /°C. Examples of such a material include titania-doped quartz glass (SiO₂-TiO₂-based glass). In addition, it is preferable to use the substrate 1 of which the surface is sufficiently planarized, and the surface roughness of the main surface of the substrate 1 is preferably 0.2 nm or less, and more preferably 0.15 nm or less in RMS value. Such surface roughness can be obtained by polishing the substrate 1 or the like. Further, the substrate 1 preferably has flatness of 100 nm or less. The size of the substrate 1 is preferably such that the size of the main surface of the substrate 1 is 152 mm square and the thickness of the substrate 1 is 6.35 mm. The substrate 1 of this size is a substrate (a substrate having a main surface size of 6 inch square and a thickness of 0.25 inch) called a so-called 6025 substrate.

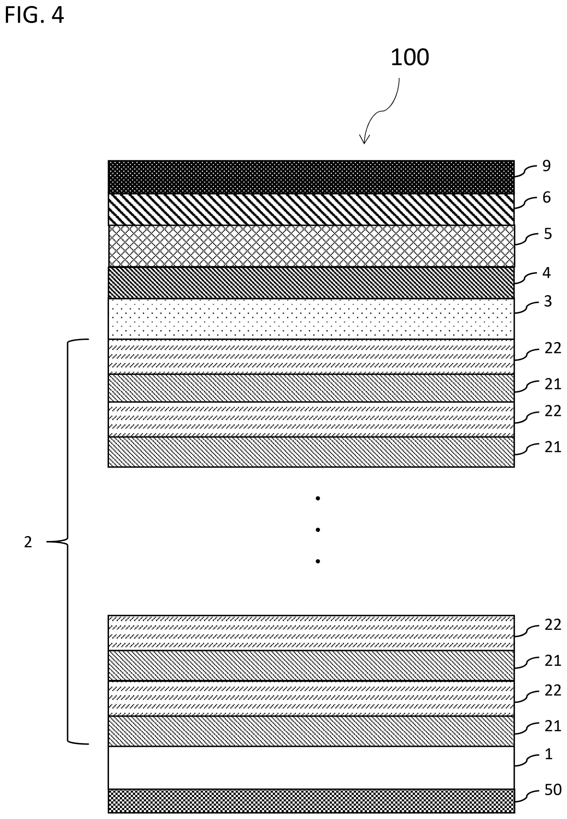

The multilayer reflective film 2 is a film that reflects exposure light in the reflective mask 110. The multilayer reflective film 2 is preferably provided in contact with one main surface of the substrate 1, but another film such as a base film may be provided between the multilayer reflective film 2 and one main surface of the substrate 1. As illustrated in FIG. 4, the multilayer reflective film 2 has a periodically laminated structure in which a high refractive index layer 21 having a relatively high refractive index to exposure light and a low refractive index layer 22 having a relatively low refractive index to exposure light are alternately laminated. Although not clearly shown in the drawings, the multilayer reflective film 2 shown in FIGS. 1 to 3 also has a periodically stacked structure in which a high refractive index layer 21 and a low refractive index layer 22 are alternately stacked.

The high refractive index layer 21 is preferably made of a material containing silicon (Si). The high refractive index layer 21 may contain one or more additive elements selected from oxygen (O), nitrogen (N), carbon (C), boron (B), and hydrogen (H), and may be composed of multiple layers including a layer containing an additive element and a layer containing no additive element. The thickness of the high refractive index layer 21 is preferably 3.5 nm or more, and more preferably 4 nm or more, and is preferably 4.9 nm or less, and more preferably 4.4 nm or less.

The low refractive index layer 22 is preferably made of a material containing molybdenum (Mo). The low refractive index layer 22 can also be made of a material containing ruthenium (Ru). A multilayer structure of Mo and Ru may be adopted. The low refractive index layer 22 may contain one or more additive elements selected from oxygen (O), nitrogen (N), carbon (C), boron (B), and hydrogen (H), and may be composed of multiple layers including a layer containing an additive element and a layer containing no additive element. The thickness of the low refractive index layer 22 is preferably 2.1 nm or more, and more preferably 2.6 nm or more, and is preferably 3.5 nm or less, and more preferably 3 nm or less.

The periodically laminated structure may include the high refractive index layer 21 and the low refractive index layer 22, and one or more high refractive index layers 21 and one or more low refractive index layers 22 may be included in one period. The number of layers included in the periodically laminated structure is two or more, and the periodically laminated structure can be composed of, for example, one high refractive index layer 21 and one low refractive index layer 22. In addition, two or more high refractive index layers 21 having different compositions (for example, having different composition ratios, or having different compositions depending on the presence or absence of the additive element) may be included, and two or more low refractive index layers 22 having different compositions (for example, having different composition ratios, or having different compositions depending on the presence or absence of the additive element) may be included. In this case, the number of layers included in the periodically laminated structure is three or more, may be four or more or five or more, and is preferably eight or less. The number of periods is preferably 20 or more, and is preferably 50 or less, and more preferably 40 or less.

The thickness of the multilayer reflective film 2 having the periodically laminated structure is adjusted according to the exposure wavelength and the incidence angle of the exposure light, and is preferably 130 nm or more and 400 nm or less, and more preferably 290 nm or less.

Examples of the method for forming the multilayer reflective film 2 include a sputtering method in which power is supplied to a target and an atmospheric gas is turned into plasma (ionization) by the supplied power to perform sputtering, and an ion beam sputtering method in which a target is irradiated with ion beams. The sputtering method includes a DC sputtering method in which a DC voltage is applied to a target and an RF sputtering method in which a high-frequency voltage is applied to a target. The sputtering method is a film forming method in which, in a state in which a sputtering gas is introduced into a chamber, a voltage is applied to a target, the gas is ionized, and a sputtering phenomenon caused by gas ions is used. In particular, a magnetron sputtering method is advantageous in terms of productivity. The power applied to the target may be either DC or RF, and in a case of DC, pulse sputtering is also included, in which the negative bias applied to the target is reversed for a short period of time to prevent charge-up of the target.

The multilayer reflective film 2 can be formed by, for example, a sputtering method using a sputtering device capable of mounting a plurality of targets. Specifically, a target can be appropriately selected and used from among a molybdenum (Mo) target for forming a layer containing molybdenum (Mo), a ruthenium (Ru) target for forming a layer containing ruthenium (Ru), a silicon (Si) target for forming a layer containing silicon (Si), and the like, and a rare gas such as a Neon (Ne) gas, an argon (Ar) gas, a krypton (Kr) gas, or a xenon (Xe) gas can be used as a sputtering gas to form the multilayer reflective film 2.

Reactive sputtering using a reactive gas can be performed for sputtering. For example, a nitrogen-containing gas such as a nitrogen (N₂) gas when a film containing nitrogen (N) is formed, an oxygen-containing gas such as an oxygen (O₂) gas when a film containing oxygen (O) is formed, a nitrogen oxide gas such as a nitrous oxide (N₂O) gas, a nitrogen monoxide (NO) gas, or a nitrogen dioxide (NO₂) gas when a film containing nitrogen (N) and oxygen (O) is formed, a carbon oxide gas such as a carbon monoxide (CO) gas or a carbon dioxide (CO₂) gas when a film containing carbon (C) and oxygen (O) is formed, a hydrogencontaining gas such as a hydrogen (H₂) gas when a film containing hydrogen (H) is formed, or a hydrocarbon gas such as a methane (CH₄) gas when a film containing carbon (C) and hydrogen (H) is formed, may be used together with a rare gas.

Furthermore, when a layer containing boron (B) is formed, a molybdenum (Mo) target in which boron (B) is added (molybdenum boride (MoB) target), a silicon (Si) target in which boron (B) is added (silicon boride (SiB) target), or the like can be used.

As shown in FIGS. 1, 2, and 4, a protective film 3 also called a capping film may be provided above the multilayer reflective film 2. The protective film 3 is a film for protecting the multilayer reflective film 2. The protective film 3 is usually provided in contact with the multilayer reflective film 2. The protective film 3 is preferably made of a material containing ruthenium (Ru) or rhodium (Rh).

Examples of the material containing ruthenium (Ru) used in the protective film 3 include ruthenium (Ru) alone and alloys containing ruthenium (Ru) and a metal or metalloid different from ruthenium (Ru). Examples of the metal or metalloid different from ruthenium (Ru) include rhodium (Rh), niobium (Nb), rhenium (Re), zirconium (Zr), titanium (Ti), chromium (Cr), and silicon (Si). The material containing ruthenium (Ru) is particularly preferably ruthenium (Ru) alone, and the protective film 3 is preferably made of ruthenium (Ru). The content of the metal or metalloid different from ruthenium (Ru) in the protective film 3 is preferably 50 atom% or less, and more preferably 30 atom% or less on average over the entire film. The lower limit of the content of the metal or metalloid different from ruthenium (Ru) in the protective film 3 is not particularly limited, but is preferably 5 atom% or more, and more preferably 10 atom% or more.

Examples of the material containing rhodium (Rh) used in the protective film 3 include rhodium (Rh) alone and alloys containing rhodium (Rh) and a metal or metalloid different from rhodium (Rh). Examples of the metal or metalloid different from rhodium (Rh) include ruthenium (Ru), niobium (Nb), rhenium (Re), zirconium (Zr), titanium (Ti), chromium (Cr), and silicon (Si). The material containing rhodium (Rh) is particularly preferably rhodium (Rh) alone, and the protective film 3 is preferably made of rhodium (Rh). The content of the metal or metalloid different from rhodium (Rh) in the protective film 3 is preferably 50 atom% or less, and more preferably 30 atom% or less on average over the entire film. The lower limit of the content of the metal or metalloid different from rhodium (Rh) in the protective film 3 is not particularly limited, but is preferably 5 atom% or more, and more preferably 10 atom% or more.

The protective film 3 may have a single layer structure or a multilayer structure in which a plurality of layers having different compositions are combined, and the single layer and the respective layers constituting the plurality of layers may have a gradient composition structure in which the composition continuously changes in the thickness direction.

The thickness of the protective film 3 is preferably 1 nm or more, and more preferably 2 nm or more, and is preferably 5 nm or less, and more preferably 4 nm or less.

The protective film 3 can be formed by sputtering using a target appropriately selected from a ruthenium (Ru) target, a rhodium (Rh) target, a target of a metal or metalloid different from the above targets, specifically, a niobium (Nb) target, a rhenium (Re) target, a zirconium (Zr) target, a titanium (Ti) target, a chromium (Cr) target, and a silicon (Si) target, and a target in which two or more selected from ruthenium (Ru), niobium (Nb), rhenium (Re), zirconium (Zr), titanium (Ti), chromium (Cr), and silicon (Si) are mixed, and using a rare gas such as a Neon (Ne) gas, an argon (Ar) gas, a krypton (Kr) gas, or a xenon (Xe) gas as a sputtering gas. For the sputtering, a magnetron sputtering method is preferably used.

In the present embodiment, as shown in FIGS. 1, 2, and 4, an absorber film 5 is provided above the multilayer reflective film 2. The absorber film 5 is a film that absorbs exposure light, specifically, EUV light, and reduces reflectance. In addition, the absorber film 5 may be a phase shift film having a phase shift function of absorbing a part of exposure light and reflecting the part as reflected light having a phase changed by about 150 to 250°. The absorber film 5 may be provided with another film, for example, the protective film 3 described above or an etching stopper film 4 described later, between the absorber film 5 and the multilayer reflective film 2. Note that the absorber film 5 may be provided directly (in contact with) the multilayer reflective film 2 without providing the protective film 3 or the etching stopper film 4.

The absorber film 5 of the present embodiment contains one or both of ruthenium (Ru) and platinum (Pt), and further contains one or both of carbon (C) and silicon (Si). By containing one or both of carbon (C) and silicon (Si), the crystallinity of the absorber film 5 containing one or both of ruthenium (Ru) and platinum (Pt) is changed, and coarse crystal grains can be reduced. Therefore, the surface roughness of the absorber film 5 can be reduced. The surface of the absorber film 5 of the present embodiment has a root mean square roughness (Sq) of 0.40 nm or less.

The carbon (C) content of the absorber film 5 can be set in the range of 4 atomic% to 40 atomic%. In addition, the silicon (Si) content of the absorber film 5 can also be set in the range of 4 atomic% to 40 atomic%. By containing carbon (C) or silicon (Si) having the above content, the crystallinity of the absorber film 5 can be changed, and the surface roughness can be reduced. When the content of carbon (C) or silicon (Si) is too small, the effect of reducing the surface roughness cannot be obtained. On the other hand, when the content of carbon (C) or silicon (Si) is too large, the refractive index of the absorber film 5 with respect to exposure light changes, and thus transfer performance may deteriorate. The absorber film 5 preferably has a microcrystalline or amorphous structure, and the crystallite size of ruthenium (Ru) or platinum (Pt) is preferably 15 nm or less, more preferably 10 nm or less, and still more preferably 5 nm or less. With such a crystallite size, the surface roughness of the absorber film 5 can be reduced.

The crystallite size (crystallite diameter) can be determined by the Scherrer equation shown below using X-ray diffraction measurement.$Crystallite size \left(nm\right) = Kλ / βcosθ$ (where K is the Scherrer constant (here, set to 0.95), λ is the measured X-ray wavelength (0.154 nm), β is the full width at half maximum in radians of the diffraction peak, and θ is the Bragg angle (here, set to the midpoint of the full width at half maximum) of the diffraction peak.)

The full width at half maximum is a width of a peak at a height indicating an average intensity of an intensity that can be regarded as a background and a peak maximum intensity when a diffraction peak is drawn with a horizontal axis as a diffraction angle 2θ and a vertical axis as a diffraction intensity, and is a value having a unit similar to the diffraction angle 2θ.

In order to obtain a preferable crystallite size as described above, in an X-ray diffraction pattern by CuK_{α} rays using an out-of-plane measurement method for the absorber film 5, the full width at half maximum of the diffraction peak having the highest intensity derived from ruthenium (Ru) or platinum (Pt) observed at diffraction angles 2θ of 30° to 50° is preferably 0.60° or more, more preferably 0.90° or more, and still more preferably 1.6° or more. When the diffraction peak does not appear in the region, the absorber film 5 has an amorphous structure, and the full width at half maximum of the diffraction peak in that case is defined as 180°.

As shown in FIG. 3, when the absorber film 5 of the reflective mask blank 100 is patterned to produce the reflective mask 110, if the film stress of the absorber film 5 is large, the amount of warpage of the substrate 1 before and after pattern formation changes, and problems such as pattern positional shifts may occur. Therefore, it is desired that the film stress of the absorber film 5 is small, and the absolute value thereof is preferably 2,000 MPa or less, more preferably 1,500 MPa or less, and still more preferably 1,000 MPa or less. By setting the content of carbon (C) or silicon (Si) in the absorber film 5 within the above range, a preferable film stress can be obtained. More specifically, by setting the carbon (C) content in the absorber film 5 to 4 atomic% or more and 40 atomic% or less, or setting the silicon (Si) content in the absorber film 5 to 4 atomic% or more and 40 atomic% or less, a preferable film stress can be obtained. In FIG. 3, reference numeral 41 denotes a pattern (etching stopper pattern) of the etching stopper film 4, and reference numeral 51 denotes a pattern (absorber pattern) of the absorber film 5.

From the viewpoint of setting the film stress, the crystallite size, and the like to more preferable ranges, when the absorber film 5 does not contain platinum (Pt) but contains ruthenium (Ru) and carbon (C) (typically, when the absorber film 5 is made of RuC), the carbon (C) content is more preferably 10 atomic% or more.

When the absorber film 5 contains ruthenium (Ru) and silicon (Si), the silicon (Si) content in the absorber film 5 is more preferably 20 atomic% or more.

When the absorber film 5 does not contain ruthenium (Ru) but contains platinum (Pt) and silicon (Si) (typically, when the absorber film 5 is made of PtSi), the silicon (Si) content is more preferably 8 atomic% or more from the viewpoint that the absolute value of the film stress can be made small, and from the viewpoint of setting the crystallite size to a more preferable range, the silicon (Si) content is preferably 20 atomic% or more.

The absorber film 5 can also contain light elements such as nitrogen (N) and oxygen (O) in addition to carbon (C) and silicon (Si), thereby reducing the surface roughness. However, noble metals such as ruthenium (Ru) and platinum (Pt) are difficult to form a compound with oxygen (O) and nitrogen (N), and even when such compounds are formed, there is a possibility that such compounds are decomposed by application of energy such as heat and the transfer performance of the reflective mask 110 is changed. Therefore, it is preferable that the absorber film 5 does not contain oxygen (O) or nitrogen (N).

When the layer containing carbon (C) is formed, the layer can be formed by simultaneously using a carbon (C) target and another target (ruthenium (Ru) target, platinum (Pt) target, and the like), and can also be formed by reactive sputtering using a carbon monoxide (CO) gas, a carbon oxide gas such as a carbon dioxide (CO₂) gas, a hydrocarbon gas such as a methane (CH₄) gas, or the like simultaneously with a rare gas. In addition, a layer containing carbon (C) can be formed using a ruthenium (Ru) target to which carbon (C) is added (ruthenium carbide (RuC) target), a platinum (Pt) target to which carbon (C) is added (platinum carbide (PtC) target), or the like.

When the layer containing silicon (Si) is formed, the layer can be formed using a silicon (Si) target and other targets (ruthenium (Ru) target, platinum (Pt) target, and the like) at the same time, and can also be formed using a ruthenium (Ru) target to which silicon (Si) is added (ruthenium silicide (RuSi) target), a platinum (Pt) target to which silicon (Si) is added (platinum silicide (PtSi) target), or the like.

The thickness of the absorption film 5 is not particularly limited since the optimum thickness varies depending on the light source and the pattern pitch during exposure. However, the thickness is preferably 20 nm or more, and more preferably 30 nm or more, and is preferably 60 nm or less, and more preferably 50 nm or less.

The etching stopper film 4 having etching characteristics different from those of the absorber film 5 may be provided between the protective film 3 and the absorber film 5. After the absorber pattern 51 is formed, the etching stopper film 4 may be removed from the opening part of the absorber pattern 51 to form a part of the pattern (refer to FIG. 3), or may remain on the multilayer reflective film 2 without being removed from the opening part of the absorber pattern 51. In any case, it is preferable to select a material or a film thickness that does not adversely affect transfer performance.

When the absorber film 5 is patterned by dry etching using a gas containing fluorine (F), the etching stopper film 4 containing chromium (Cr) can be used. In addition, when the absorber film 5 is patterned by dry etching using a gas containing chlorine (Cl) and oxygen (O), the etching stopper film 4 containing any one or more of niobium (Nb), tantalum (Ta), and silicon (Si) can be used. The etching stopper film 4 may further contain oxygen (O), nitrogen (N), carbon (C), boron (B), and the like.

The etching stopper film 4 can be formed by sputtering. Specifically, the etching stopper film 4 can be formed by using metallic or metalloid targets such as chromium (Cr) targets, niobium (Nb) targets, tantalum (Ta) targets, and silicon (Si) targets, or compound targets such as chromium compound targets, niobium compound targets, tantalum compound targets, and silicon compound targets (targets containing a metal or metalloid such as Cr, Nb, Ta, or Si and another metal or metalloid element, or a light element such as oxygen (O), nitrogen (N), carbon (C), or boron (B)), and by performing sputtering using a rare gas such as neon (Ne) gas, argon (Ar) gas, krypton (Kr) gas, or xenon (Xe) gas as a sputtering gas, or reactive sputtering using, together with a rare gas, a reactive gas such as an oxygen-containing gas, nitrogen-containing gas, or carbon-containing gas. The film thickness of the etching stopper film 4 is not particularly limited, but is usually about 2 to 10 nm.

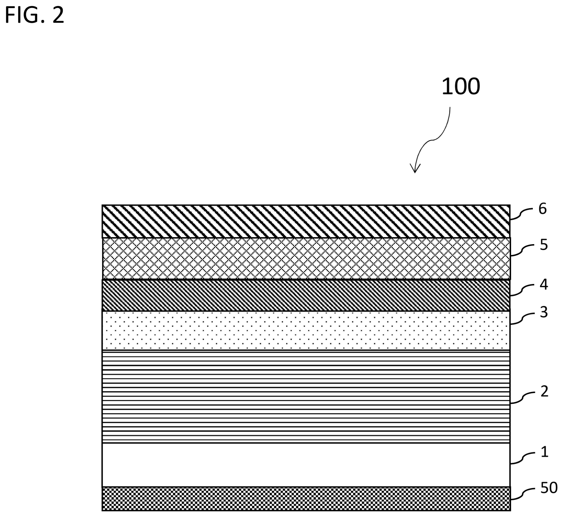

As shown in FIG. 2, a hard mask film 6 (an etching mask film of the absorber film 5) which is preferably in contact with the absorber film 5 and has an etching characteristic different from that of the absorber film 5 may be provided on the side of the absorber film 5 that is spaced apart from the substrate 1. The hard mask film 6 is a film that functions as an etching mask when the absorber film 5 is dry-etched. After the absorber pattern 51 is formed, the hard mask film 6 may be left on the reflective mask 110 as a reflectance reduction layer for reducing the reflectance at the wavelength of light used in inspection such as pattern inspection, or may be removed not to remain on the reflective mask 110.

The thickness of the hard mask film 6 is not particularly limited, but when the thickness is too thin, the hard mask film 6 may not function as a hard mask, and when the thickness is too thick, processing characteristics may deteriorate, and thus, the thickness is preferably 1 nm or more, more preferably 2 nm or more, and still more preferably 5 nm or more, and is preferably 20 nm or less, and more preferably 10 nm or less.

When the absorber film 5 is patterned by dry etching using a gas containing fluorine (F), the hard mask film 6 containing chromium (Cr) can be used. In addition, when the absorber film 5 is patterned by dry etching using a gas containing chlorine (Cl) and oxygen (O), the hard mask film 6 containing any one or more of niobium (Nb), tantalum (Ta), and silicon (Si) can be used. The hard mask film 6 may further contain oxygen (O), nitrogen (N), carbon (C), boron (B), and the like.

The hard mask film 6 can be formed by sputtering. Specifically, the hard mask film 6 can be formed by using metallic or metalloid targets such as chromium (Cr) targets, niobium (Nb) targets, tantalum (Ta) targets, and silicon (Si) targets, or compound targets such as chromium compound targets, niobium compound targets, tantalum compound targets, and silicon compound targets (targets containing a metal or metalloid such as Cr, Nb, Ta, or Si and another metal or metalloid element, or a light element such as oxygen (O), nitrogen (N), carbon (C), or boron (B)), and by performing sputtering using a rare gas such as neon (Ne) gas, argon (Ar) gas, krypton (Kr) gas, or xenon (Xe) gas as a sputtering gas, or reactive sputtering using, together with a rare gas, a reactive gas such as an oxygen-containing gas, nitrogen-containing gas, or carbon-containing gas. The film thickness of the hard mask film 6 is not particularly limited, but is usually about 2 to 10 nm.

As shown in FIGS. 1 to 4, an electrically conductive film (conductive film) 50 used to electrostatically chuck the reflective mask 110 to an exposure device (for example, an EUV scanner) may be provided on another main surface (back surface), which is a surface opposite to the one main surface of the substrate 1, preferably in contact with the other main surface.

The conductive film 50 preferably has a sheet resistance of 100 Ω/□ or less, and its material is not particularly limited. Examples of the material of the conductive film 50 include a material containing tantalum (Ta) or chromium (Cr). In addition, the material containing tantalum (Ta) may contain oxygen (O), nitrogen (N), carbon (C), boron (B), and the like. The material containing chromium (Cr) may contain oxygen (O), nitrogen (N), carbon (C), and the like. Examples of the material containing tantalum (Ta) that can be used to form the conductive film 50 include Ta alone and tantalum (Ta) compounds such as TaO, TaN, TaON, TaC, TaCN, TaCO, TaCON, TaB, TaOB, TaNB, TaONB, TaCB, TaCNB, TaCOB, and TaCONB. Specific examples of the material containing chromium (Cr) that can be used to form the conductive film 50 include Cr alone and chromium (Cr) compounds such as CrO, CrN, CrON, CrC, CrCN, CrCO, and CrCON.

The thickness of the conductive film 50 is not particularly limited as long as the conductive film 50 functions for electrostatic chucking, but is usually about 20 to 300 nm. The thickness of the conductive film 50 is preferably set so that the film stress is balanced with the films and the film patterns formed on one main surface (front surface) side after formation of the reflective mask 110, that is, after formation of the pattern of the absorption film 5. The conductive film 50 may be formed before the multilayer reflective film 2 is formed, or may be formed after all the films of the substrate 1 on the multilayer reflective film 2 side (front surface side) are formed. In addition, the conductive film 50 may be formed after some of the films of the substrate 1 on the multilayer reflective film 2 side are formed, and then the remaining films of the substrate 1 on the multilayer reflective film 2 side may be formed. The conductive film 50 can be formed by, for example, a magnetron sputtering method.

The reflective mask blank 100 may further have a resist film 9 formed on the side farthest from the substrate 1 (refer to FIG. 4). In the present embodiment, the resist film 9 is preferably an electron beam (EB) resist. In addition, the resist film 9 is preferably removable by SPM cleaning. In the aspect shown in FIG. 4, the hard mask film 6 is provided in contact with the upper surface of the absorber film 5, and the resist film 9 is provided in contact with the upper surface of the hard mask film 6.

### [Examples]

Hereinafter, examples of the present invention will be specifically described with reference to Examples and Comparative Examples, but the present invention is not limited to the following Examples.

### [Example 1]

As the substrate 1, a low thermal expansion glass substrate (SiO₂-TiO₂-based glass substrate) having a size of 152 mm square and a thickness of 6.35 mm was used. The substrate 1 had a Young's modulus of 67.6 GPa and a Poisson's ratio of 0.17, and the flatness within a 142 mm square of the central part of the main surface of the substrate 1 was 100 nm or less.

The multilayer reflective film 2 was formed on one main surface of the substrate 1 by DC magnetron sputtering with the substrate 1 placed in a sputtering chamber equipped with a silicon (Si) target and a molybdenum (Mo) target. Specifically, first, power of 1,000 W was applied to a silicon (Si) target while flowing argon (Ar) gas at a flow rate of 12 SCCM in the chamber, a silicon (Si) layer having a thickness of 4 nm was formed as the high refractive index layer 21, and the application of power to the silicon (Si) target was stopped. Next, while argon (Ar) gas was flown into the chamber at a flow rate of 15 SCCM, power of 750 W was applied to the molybdenum (Mo) target, a molybdenum (Mo) layer having a thickness of 3 nm was formed as the low refractive index layer 22, and the application of power to the molybdenum (Mo) target was stopped. The operation of forming the high refractive index layer 21 and the low refractive index layer 22 was set to 1 cycle, and this was repeated 40 cycles to form a periodic stacked structure. After the formation of the low refractive index layer 22 of the 40th cycle, a silicon (Si) layer of 4 nm was formed by the above method, and further, a 1 nm molybdenum (Mo) layer was formed by the above method, thereby forming the multilayer reflective film 2.

The protective film 3 was formed on the multilayer reflective film 2 by DC magnetron sputtering. Specifically, the substrate 1 on which the multilayer reflective film 2 was formed was placed in a sputtering chamber equipped with a ruthenium (Ru) target, and a ruthenium (Ru) film having a thickness of 2 nm was formed as the protective film 3 on the multilayer reflective film 2 by applying power of 200 W to the ruthenium (Ru) target while flowing argon (Ar) gas at a flow rate of 28 SCCM.

A niobium oxide (NbO) film (Nb:O = 2:5 (atomic ratio)) having a thickness of 2 nm was formed on the protective film 3 as the etching stopper film 4. A niobium oxide (NbO) film was formed by first placing the substrate 1 on which the multilayer reflective film 2 and the protective film 3 were formed in a sputtering chamber equipped with a niobium (Nb) target, applying power of 200 W to the niobium (Nb) target while flowing argon (Ar) gas at a flow rate of 28 SCCM in the chamber to form a niobium (Nb) film by DC sputtering, and then subjecting the niobium (Nb) film to a heat treatment at 150°C for 10 minutes in the atmosphere to oxidize the niobium (Nb) film.

The absorber film 5 was formed on the etching stopper film 4 by DC magnetron sputtering using a sputtering apparatus capable of mounting a plurality of targets and simultaneously discharging electricity. Specifically, the substrate 1 on which the multilayer reflective film 2, the protective film 3, and the etching stopper film 4 were formed was placed in a sputtering chamber equipped with a ruthenium (Ru) target and a carbon (C) target, and power was applied to the ruthenium (Ru) target and the carbon (C) target while an argon (Ar) gas was flown at a flow rate of 15 SCCM to form a ruthenium carbide (RuC) film having a thickness of 40 nm as the absorber film 5. The carbon (C) content was 15 atomic%.

In this manner, a reflective mask blank 100 including the substrate 1, the multilayer reflective film 2, the protective film 3, the etching stopper film 4, and the absorber film 5 was obtained.

The inside of a 1 µm square of the surface of the absorber film 5 of the obtained reflective mask blank 100 was measured by an atomic force microscope (AFM), and the root mean square roughness (Sq) was 0.14 nm.

When the surface of the absorber film 5 of the obtained reflective mask blank 100 was subjected to defect inspection by a defect inspection apparatus using a dark field optical system using ultraviolet light having a wavelength of 213 nm, no pseudo-defects caused by the surface roughness of the reflective mask blank 100 were detected.

The film stress was measured from the change (ΔTIR) in the warpage amount within a 142 mm square of the central part of the substrate 1 before and after formation of the absorber film 5 of the reflective mask blank 100, and the film stress of the absorber film 5 was -910 MPa when the compressive stress was negative and the tensile stress was positive.

The etching stopper film 4 and the absorber film 5 of the reflective mask blank 100 of Example 1 were formed in this order on a quartz glass substrate, and an X-ray diffraction pattern by an out-of-plane measurement method using a CuK_{α} ray was measured for a diffraction angle (2θ) between 30° and 50°. As a result, a diffraction peak having the maximum intensity was observed at a diffraction angle (2θ) of 45.1°, and the full width at half maximum thereof was 4.14°.

In addition, the crystallite size (crystallite diameter) calculated from the following Scherrer equation was 2.2 nm. $Crystallite size \left(nm\right) = Kλ / βcosθ$ (where K is the Scherrer constant (here, set to 0.95), λ is the measured X-ray wavelength (0.154 nm), β is the full width at half maximum in radians of the diffraction peak, and θ is the Bragg angle (here, set to the midpoint of the full width at half maximum) of the diffraction peak.)

### [Examples 2 to 5]

The reflective mask blank 100 was obtained in the same manner as in Example 1 except that the absorber film 5 had a thickness of 28 nm, and the carbon (C) content was set to 5 atomic%, 15 atomic%, 26 atomic%, and 40 atomic% for Examples 2, 3, 4, and 5, respectively.

Regarding the absorber film 5 of the obtained reflective mask blank 100, the root mean square roughness (Sq) was measured in the same manner as in Example 1, and was 0.32 nm, 0.11 nm, 0.11 nm, and 0.14 nm for Examples 2, 3, 4, and 5, respectively.

When the surface of the absorber film 5 of the obtained reflective mask blank 100 was subjected to defect inspection by the same method as in Example 1, no pseudo-defects due to the surface roughness of the reflective mask blank 100 were detected in any of Examples 2 to 5.

The film stress of the absorber film 5 of the obtained reflective mask blank 100 was measured in the same manner as in Example 1, and was -1,600 MPa, -930 MPa, 90 MPa, and -210 MPa for Examples 2, 3, 4, and 5, respectively.

The X-ray diffraction pattern of the absorber film 5 was measured in the same manner as in Example 1, and as a result, diffraction peaks with maximum intensity were observed at diffraction angles (2θ) of 41.8°, 44.9°, 42.6°, and 42.6° for Examples 2, 3, 4, and 5, respectively, with full widths at half maximum of 1.10°, 4.52°, 4.76°, and 6.58° for Examples 2, 3, 4, and 5, respectively.

In addition, the crystallite sizes calculated from the above Scherrer equation were 8.1 nm, 2.0 nm, 1.9 nm, and 1.4 nm for Examples 2, 3, 4, and 5, respectively.

From the comparison of Example 2 to 5, it was found that the surface roughness, the film stress, and the crystallite size were changed when the carbon (C) content in the absorber film 5 was changed.

### [Example 6]

The reflective mask blank 100 was obtained in the same manner as in Example 2 except that the absorber film 5 was formed while flowing argon (Ar) gas at a flow rate of 32 SCCM.

Regarding the absorber film 5 of the obtained reflective mask blank 100, the root mean square roughness (Sq) was measured in the same manner as in Example 1, and was 0.21 nm.

When the surface of the absorber film 5 of the obtained reflective mask blank 100 was subjected to defect inspection by the same method as in Example 1, no pseudo-defects due to the surface roughness of the reflective mask blank 100 were detected.

The film stress of the absorber film 5 of the obtained reflective mask blank 100 was measured in the same manner as in Example 1, and was -910 MPa.

The X-ray diffraction pattern of the absorber film 5 was measured in the same manner as in Example 1, and as a result, a diffraction peak with maximum intensity was observed at a diffraction angle (2θ) of 41.8°, with a full width at half maximum of 1.17°.

In addition, the crystallite size calculated from the above Scherrer equation was 7.7 nm.

From the comparison with Example 2, it has been found that the film stress changes when the flow rate of the argon (Ar) gas at the time of forming the absorber film 5 is changed.

### [Examples 7 to 9]

The reflective mask blank 100 was obtained in the same manner as in Example 1 except that the absorber film 5 was a ruthenium silicide (RuSi) film using a silicon (Si) target instead of the carbon (C) target, with silicon (Si) content set to 15 atomic%, 29 atomic%, and 31 atomic% for Examples 7, 8, and 9, respectively.

Regarding the absorber film 5 of the obtained reflective mask blank 100, the root mean square roughness (Sq) was measured in the same manner as in Example 1, and was 0.13 nm, 0.10 nm, and 0.11 nm for Examples 7, 8, and 9, respectively.

When the surface of the absorber film 5 of the obtained reflective mask blank 100 was subjected to defect inspection by the same method as in Example 1, no pseudo-defects due to the surface roughness of the reflective mask blank 100 were detected in any of Examples 7 to 9.

The film stress of the absorber film 5 of the obtained reflective mask blank 100 was measured in the same manner as in Example 1, and was -1,900 MPa, -140 MPa, and - 60 MPa for Examples 7, 8, and 9, respectively.

The X-ray diffraction pattern of the absorber film 5 was measured in the same manner as in Example 1, and as a result, diffraction peaks with maximum intensity were observed at diffraction angles (2θ) of 43.7°, 43.2°, and 42.7° for Examples 7, 8, and 9, respectively, with full widths at half maximum of 1.61°, 3.08°, and 4.27° for Examples 7, 8, and 9, respectively.

In addition, the crystallite sizes calculated from the above Scherrer equation were 5.6 nm, 2.9 nm, and 2.1 nm for Examples 7, 8, and 9, respectively.

From the results of Example 7 to 9, it was found that the surface roughness, the film stress, and the crystallite size were changed when the content of silicon (Si) in the absorber film 5 was changed.

### [Examples 10 and 11]

The reflective mask blank 100 was obtained in the same manner as in Example 1 except that the absorber film 5 was a platinum silicide (PtSi) film formed to a thickness of 50 nm using a silicon (Si) target instead of the carbon (C) target, and a platinum (Pt) target instead of ruthenium (Ru) target, with the silicon (Si) content set to 6 atomic% and 9 atomic% in Examples 10 and 11, respectively.

Regarding the absorber film 5 of the obtained reflective mask blank 100, the root mean square roughness (Sq) was measured in the same manner as in Example 1, and was 0.21 nm and 0.25 nm for Examples 10 and 11, respectively.

When the surface of the absorber film 5 of the obtained reflective mask blank 100 was subjected to defect inspection by the same method as in Example 1, no pseudo-defects due to the surface roughness of the reflective mask blank 100 were detected in either of Examples 10 and 11.

The film stress of the absorber film 5 of the obtained reflective mask blank 100 was measured in the same manner as in Example 1, and was -1,130 MPa and -170 MPa for Examples 10 and 11, respectively.

The X-ray diffraction pattern of the absorber film 5 was measured in the same manner as in Example 1, and as a result, diffraction peaks with maximum intensity were observed at diffraction angles (2θ) of 39.9° and 40.2° for Examples 10 and 11, respectively, with full widths at half maximum of 0.61° and 0.72° for Examples 10 and 11, respectively.

In addition, the crystallite sizes calculated from the above Scherrer equation were 14.5 nm and 12.4 nm for Examples 10 and 11, respectively.

### [Example 12]

The reflective mask blank 100 was obtained in the same manner as in Example 1, except that the absorber film 5 was a platinum carbide (PtC) film formed to a thickness of 30 nm using a platinum (Pt) target instead of a ruthenium (Ru) target, with the carbon (C) content set to 19 atomic%.

Regarding the absorber film 5 of the obtained reflective mask blank 100, the root mean square roughness (Sq) was measured in the same manner as in Example 1, and was 0.17 nm.

When the surface of the absorber film 5 of the obtained reflective mask blank 100 was subjected to defect inspection by the same method as in Example 1, no pseudo-defects due to the surface roughness of the reflective mask blank 100 were detected.

The film stress of the absorber film 5 of the obtained reflective mask blank 100 was measured in the same manner as in Example 1, and was -1,400 MPa.

The X-ray diffraction pattern of the absorber film 5 was measured in the same manner as in Example 1, and as a result, a diffraction peak with maximum intensity was observed at a diffraction angle (2θ) of 39.6°, with a full width at half maximum of 1.11°.

In addition, the crystallite size calculated from the above Scherrer equation was 8.0 nm.

### [Example 13]

The reflective mask blank 100 was obtained in the same manner as in Example 1, except that the absorber film 5 was a platinum-ruthenium silicide (PtRuSi) film formed to a thickness of 30 nm using a ruthenium (Ru) target, a platinum (Pt) target, and a silicon (Si) target, with the ruthenium (Ru) content set to 33 atomic%, the platinum (Pt) content set to 47 atomic%, and the silicon (Si) content set to 20 atomic%.

Regarding the absorber film 5 of the obtained reflective mask blank 100, the root mean square roughness (Sq) was measured in the same manner as in Example 1, and was 0.12 nm.

When the surface of the absorber film 5 of the obtained reflective mask blank 100 was subjected to defect inspection by the same method as in Example 1, no pseudo-defects due to the surface roughness of the reflective mask blank 100 were detected.

The film stress of the absorber film 5 of the obtained reflective mask blank 100 was measured in the same manner as in Example 1, and was -800 MPa.

The X-ray diffraction pattern of the absorber film 5 was measured in the same manner as in Example 1, and as a result, a diffraction peak with maximum intensity was observed at a diffraction angle (2θ) of 40.5°, with a full width at half maximum of 1.33°.

In addition, the crystallite size calculated from the above Scherrer equation was 6.7 nm.

### [Example 14]

The reflective mask blank 100 was obtained in the same manner as in Example 13, except that the absorber film 5 was a platinum-ruthenium carbide (PtRuC) film formed using a carbon (C) target instead of a silicon (Si) target, with the ruthenium (Ru) content set to 36 atomic%, the platinum (Pt) content set to 52 atomic%, and the carbon (C) content set to 12 atomic%.

Regarding the absorber film 5 of the obtained reflective mask blank 100, the root mean square roughness (Sq) was measured in the same manner as in Example 1, and was 0.16 nm.

When the surface of the absorber film 5 of the obtained reflective mask blank 100 was subjected to defect inspection by the same method as in Example 1, no pseudo-defects due to the surface roughness of the reflective mask blank 100 were detected.

The film stress of the absorber film 5 of the obtained reflective mask blank 100 was measured in the same manner as in Example 1, and was -1,970 MPa.

The X-ray diffraction pattern of the absorber film 5 was measured in the same manner as in Example 1, and as a result, a diffraction peak with maximum intensity was observed at a diffraction angle (2θ) of 40.1°, with a full width at half maximum of 1.20°.

In addition, the crystallite size calculated from the above Scherrer equation was 7.4 nm.

### [Example 15]

The reflective mask blank 100 was obtained in the same manner as in Example 10, except that the absorber film 5 was a platinum silicide (PtSi) film formed to a thickness of 30 nm, with the silicon (Si) content set to 36 atomic%.

Regarding the absorber film 5 of the obtained reflective mask blank 100, the root mean square roughness (Sq) was measured in the same manner as in Example 1, and was 0.16 nm.

When the surface of the absorber film 5 of the obtained reflective mask blank 100 was subjected to defect inspection by the same method as in Example 1, no pseudo-defects due to the surface roughness of the reflective mask blank 100 were detected.

The film stress of the absorber film 5 of the obtained reflective mask blank 100 was measured in the same manner as in Example 1, and was 30 MPa.

The X-ray diffraction pattern of the absorber film 5 was measured in the same manner as in Example 1, and as a result, a diffraction peak with maximum intensity was observed at a diffraction angle (2θ) of 40.4°, with a full width at half maximum of 8.11°.

In addition, the crystallite size calculated from the above Scherrer equation was 1.1 nm.

### [Comparative Example 1]

The reflective mask blank 100 was obtained in the same manner as in Example 1, except that the absorber film 5 was formed as a ruthenium (Ru) film consisting solely of ruthenium (Ru) without containing carbon (C), using only a ruthenium (Ru) target.

Regarding the absorber film 5 of the obtained reflective mask blank 100, the root mean square roughness (Sq) was measured in the same manner as in Example 1, and was 0.64 nm.

When the surface of the absorber film 5 of the obtained reflective mask blank 100 was subjected to defect inspection by the same method as in Example 1, pseudo-defects due to the surface roughness of the reflective mask blank 100 were detected on the entire inspection range, and the inspection could not be completed in a normal inspection time.

The film stress of the absorber film 5 of the obtained reflective mask blank 100 was measured in the same manner as in Example 1, and was -2,820 MPa.

The X-ray diffraction pattern of the absorber film 5 was measured in the same manner as in Example 1, and as a result, a diffraction peak with maximum intensity was observed at a diffraction angle (2θ) of 42.0°, with a full width at half maximum of 0.46°.

In addition, the crystallite size calculated from the above Scherrer equation was 19.4 nm.

### [Comparative Example 2]

The reflective mask blank 100 was obtained in the same manner as in Example 11, except that the absorber film 5 was a platinum (Pt) film consisting solely of platinum (Pt) without containing silicon (Si), formed using only a platinum (Pt) target.

Regarding the absorber film 5 of the obtained reflective mask blank 100, the root mean square roughness (Sq) was measured in the same manner as in Example 1, and was 0.59 nm.

When the surface of the absorber film 5 of the obtained reflective mask blank 100 was subjected to defect inspection by the same method as in Example 1, pseudo-defects due to the surface roughness of the reflective mask blank 100 were detected on the entire inspection range, and the inspection could not be completed in a normal inspection time.

### Reference Signs List

- 1: Substrate
- 2: Multilayer reflective film
- 3: Protective film
- 4: Etching stopper film
- 5: Absorption film
- 6: Hard mask film
- 41: Pattern of etching stopper film (etching stopper pattern)
- 51: Pattern of absorber film (absorber pattern)
- 100: Reflective mask blank
- 110: Reflective mask

## Claims

1. A reflective mask blank comprising:
a substrate (1);
a multilayer reflective film (2) that reflects exposure light and that is provided on one main surface of the substrate (1); and
an absorber film (5) provided above the multilayer reflective film (2),
wherein the absorber film (5) contains one or both of ruthenium (Ru) and platinum (Pt), and further contains one or both of carbon (C) and silicon (Si), and
wherein a surface of the absorber film (5) has a root mean square roughness (Sq) of 0.40 nm or less.

2. The reflective mask blank according to claim 1,
wherein a full width at half maximum corresponding to a diffraction angle 2θ of diffraction peak with highest intensity observed between diffraction angles 2θ of 3θ° and 50° in an X-ray diffraction pattern for the absorber film (5) by an out-of-plane measurement method using CuK_{α} rays is 0.60° or more.

3. The reflective mask blank according to claim 1 or 2,
wherein an absolute value of film stress of the absorber film (5) is 2,000 MPa or less.

4. The reflective mask blank according to any one of claims 1 to 3,
wherein the absorber film (5) includes carbon (C), and
wherein a content rate of the carbon (C) in the absorber film (5) is 4 atomic% or more and 40 atomic% or less.

5. The reflective mask blank according to any one of claims 1 to 4,
wherein the absorber film (5) includes silicon (Si), and
wherein a content rate of the silicon (Si) in the absorber film (5) is 4 atomic% or more and 40 atomic% or less.

6. The reflective mask blank according to any one of claims 1 to 5 further comprising
a protective film (3) containing one or both of ruthenium (Ru) and rhodium (Rh) and provided between the multilayer reflective film (2) and the absorber film (5).

7. The reflective mask blank according to claim 6 further comprising
an etching stopper film (4) provided between the protective film (3) and the absorber film (5), the etching stopper film (4) containing at least one selected from niobium (Nb), tantalum (Ta), silicon (Si), and chromium (Cr).

8. The reflective mask blank according to claim 6 or 7 further comprising
a hard mask film (6) provided above the absorber film (5), the hard mask film (6) containing at least one selected from niobium (Nb), tantalum (Ta), silicon (Si), and chromium (Cr).

9. A reflective mask,
wherein the absorber film (5) of the reflective mask blank according to any one of claims 1 to 8 has an absorber pattern.
